# EUROPÄISCHE PATENTSCHRIFT

(11) **EP 3 374 742 B1**
(45) Veröffentlichungstag und Bekanntmachung des Hinweises auf die Patenterteilung: **13.09.2023**
(21) Anmeldenummer: 16790382.2
(22) Anmeldetag: 03.11.2016
(51) Int. Cl.: G01F 23/284, G01S 7/03, G01S 13/88, H01Q 1/22, H01L 23/00, H01Q 9/04

(54) **RADARBASIERTER FÜLLSTANDSENSOR**
RADAR BASED FLUID LEVEL SENSOR
CAPTEUR DI NIVEAU DE FLUIDE DU TYPE RADAR

(30) Priorität: 13.11.2015 DE 102015119690
(43) Veröffentlichungstag der Anmeldung: 19.09.2018
(73) Patentinhaber: Endress+Hauser SE+Co. KG, 79689 Maulburg (DE)
(72) Erfinder: MAYER, Winfried, 89290 Buch (DE); HITZLER, Martin, 89407 Dillingen (DE); WALDSCHMIDT, Christian, 89081 Ulm (DE)
(74) Vertreter: Koslowski, Christine Adelheid
(86) Internationale Anmeldenummer: PCT/EP2016/076562
(87) Internationale Veröffentlichungsnummer: WO 2017/080908

(56) Entgegenhaltungen:
- US-A1- 2007 026 567
- US-A1- 2007 109 178
- US-A1- 2007 164 420
- US-A1- 2013 207 274

## Beschreibung

Die Erfindung bezieht sich auf einen radarbasierten Füllstandsensor mit mindestens einem Halbleiterelement.

Mit Millimeterwellen lassen sich Füllstände von wenigen cm bis zu ca. 500m hochgenau messen. Mit der Erschließung immer höherer Frequenzbänder können hohe Strahlbündelungen mit immer kleineren Antennenabmessungen realisiert werden. Da bei höheren Operationsfrequenzen (79Gz, 150GHz...) aus technischen und regulatorischen Gründen auch größere absolute Bandbreiten möglich sind, lässt sich zudem die Füllstandsauflösung signifikant steigern. Durch beide Vorteile kann die Zuverlässigkeit von radarbasierten Füllstandsensoren in Behältern mit komplexen Einbauten erheblich gesteigert werden.

Zur Realisierung von Schaltungen bei Frequenzen über 60GHz sind die in der Elektronik üblichen Aufbau- und Verbindungstechnologien, insbesondere die SMD-Technologie nicht mehr nutzbar. Da die Dimensionen der Verbindungsstrukturen wie Bonddrähte oder Lötstellen in der Größenordnung der Wellenlänge der Millimeterwellen liegen, stören sie als parasitäre Elemente das Schaltungsverhalten. Darüber hinaus verursachen viele der in der Elektronik üblichen Werkstoffe mit der Frequenz steigende Verluste, durch welche die Millimeterwellensignale schon über kurze Distanzen erheblich gedämpft werden. Die Realisierung leistungsfähiger und zuverlässiger Millimeterwellenschaltungen mit Standardtechnologien ist daher mit zunehmender Frequenz schwieriger und wird irgendwann unmöglich. Dies wirkt sich erheblich auf die Auflösung und die Genauigkeit der Füllstandsmessung aus.

In den Veröffentlichungsschriften US 2007/026567 A1, US 2013/207274 A1 und US 2007/0164420 A1 sind Radar-basierte Sensoren gezeigt, die zur Erzeugung der Millimeterwellensignale jeweils auf einen Halbleiter-Chip basieren, wobei ein Koppelelement am Halbleiter-Chip zu deren Auskopplung dient. Zudem weist das Chipgehäuse des Halbleiter-Chips eine galvanisch leitfähige Resonatorstruktur auf. Dabei ist die Resonatorstruktur über entsprechende, metallische Verbindungsleitungen mit dem Koppelelement verbunden, so dass die Resonatorstruktur als Antenne zum Aussenden/Empfang der Millimeterwellensignale dient.

Der Erfindung liegt die Aufgabe zugrunde, einen radarbasierten Füllstandsensor mit einer hohen Füllstandsauflösung und ein entsprechendes Verfahren zum Herstellen solch eines Füllstandsensors bereitzustellen.

Die Aufgabe wird durch den Gegenstand der Erfindung gelöst. Gegenstand der Erfindung ist ein radarbasierter Füllstandsensor mit mindestens einem Halbleiterelement, umfassend mindestens einen Halbleiter-Chip und ein Chipgehäuse, in dem der mindestens eine Halbleiter-Chip angeordnet ist, wobei der mindestens eine Halbleiter-Chip mindestens ein Koppelelement aufweist, das als Signaltor für elektromagnetische Wellen, bevorzugt im Millimeterwellenbereich, dient, wobei an einer Teiloberfläche des Chipgehäuses mindestens eine erste dielektrische Resonatorstruktur derart angeordnet ist, so dass das Chipgehäuse die Resonatorstruktur definiert vom Koppelelement beabstandet. Dabei weist das Chipgehäuse an der Teiloberfläche, an welcher die mindestens erste Resonatorstruktur angeordnet ist, eine Vertiefung in Richtung des mindestens einen Halbleiter-Chips auf. Sofern zwischen dem Halbleiter-Chip und der ersten Resonatorstruktur mindestens eine zweite Resonatorstruktur angeordnet ist, weist das Chipgehäuse an der Teiloberfläche, an welcher die mindestens erste Resonatorstruktur angeordnet ist, die Vertiefung entsprechend in Richtung der mindestens zweiten Resonatorstruktur auf.

Derzeit können Chipgehäuse, die als QFN-Gehäuse (engl. QFN: Quad Flat No Leads Package) ausgestaltet sind, von den gängigen Standardgehäusen der SMD-Technik als günstigste Lösung zur Umsetzung des erfindungsgemäßen Verfahrens betrachtet werden. Dies soll jedoch nicht ausschließen, dass auch andere oder zukünftige Standardgehäuseformen von Chipgehäusen (z. B. DIL, SOP, SSOP, BGA) gegebenenfalls für andere Anwendungsfälle zur Umsetzung der Erfindungsidee vorteilhaft angewendet werden könnten.

Gemäß einer vorteilhaften Ausführungsform ist das Halbleiterelement an einer Leiterkarte angeordnet, wobei eine dielektrische Linse dermaßen an der Leiterkarte befestigt ist, dass das Halbleiterelement in dem Brennpunkt der Linse liegt.

Gemäß einer vorteilhaften Ausgestaltung ist das Halbleiterelement an einer Leiterkarte angeordnet, wobei Hohlleiter zum Übertragen der durch das Halbleiterelement erzeugten elektromagnetischen Wellen an der Leiterkarte angeordnet sind. Das Koppelelement dient dabei zur Ankopplung des Halbleiter-Chips an einen Hohlleiter. Dabei kann ein dielektrischer Wellenleiter anstatt des abstrahlenden zweiten Resonators als Verbindung zu dem Hohlleiter verwendet werden.

Gemäß einer vorteilhaften Ausgestaltung ist ein dielektrischer Wellenleiter in der Vertiefung angeordnet, so dass die von dem Koppelelement ausgekoppelten elektromagnetischen Wellen mittels des dielektrischen Wellenleiters in einen Hohlleiter geführt werden, der bevorzugt eine Anschlussstruktur zum Einkoppeln der elektromagnetischen Wellen aufweist.

Die Aufgabe der Erfindung wird ebenfalls durch ein Verfahren gelöst. Das Verfahren ist ein Verfahren zum Herstellen eines erfindungsgemäßen radarbasierten Füllstandsensors, umfassend die Verfahrensschritte: Durchleuchten des Halbleiterelements, so dass eine Lage des Halbleiter-Chips relativ zum Chipgehäuse bestimmbar ist,
teilweises Abtragen des Chipgehäuses bis eine Teiloberfläche des Chipgehäuses mindestens eine Vertiefung in Richtung des mindestens einen Koppelelements aufweist, Erzeugen einer ersten Resonatorstruktur in der mindestens einen Vertiefung, so dass der Abstand zwischen der mindestens ersten Resonatorstruktur und dem Koppelelement des Halbleiter-Chips verringert ist. Dabei ist die erste Resonatorstruktur als eine dielektrische Resonatorstruktur, die aus Quarzglas, Keramik oder Kunststoff gefertigt ist, ausgestaltet.

Gemäß einer günstigen Weiterbildung geschieht das Erzeugen der ersten Resonatorstruktur in der mindestens einen Vertiefung mittels 2D- oder 3D-Druck-Verfahren oder MID-Verfahren (engl. MID: Molded Interconnect Devices).

Gemäß einer günstigen Variante geschieht das Durchleuchten des Halbleiterelements mittels Röntgenstrahlung.

Gemäß einer günstigen Ausführungsform geschieht das teilweise Abtragen des Chipgehäuses mittels Fräsen oder Laserbearbeitung.

Gemäß einer günstigen Ausgestaltung umfasst die erste Resonatorstruktur ein rechteckiges Metallplättchen, wobei eine Kantenlänge der ersten Resonatorstruktur einer halben Wellenlänge oder dem ganzzahligen Vielfachen einer halben Wellenlänge der elektromagnetischen Wellen entspricht.

Die Erfindung wird anhand der nachfolgenden Zeichnungen näher erläutert. Es zeigt:
Fig. 1: einen Querschnitt eines radarbasierten Füllstandsensors mit einem Halbleiterelement umfassend eine erste Resonatorstruktur,
Fig. 2: einen Querschnitt eines radarbasierten Füllstandsensors mit einem Halbleiterelement 2 umfassend eine erste und eine zweite Resonatorstruktur,
Fig. 3: eine Draufsicht auf einen Halbleiter-Chip,
Fig. 4: a) eine Seitenansicht eines Halbleiter-Chips und eines Exposed-Pads, b) Seitenansicht eines Halbleiter-Chips auf einem Exposed-Pad,
   c) Draufsicht eines fertigen Halbleiterelements,
Fig. 5: a) Röntgenbild eines Halbleiterelements,
   b) Draufsicht eines fertigen Halbleiterelements mit zwei Vertiefungen,
   c) Draufsicht eines fertigen Halbleiterelements mit jeweils einer ersten Resonatorstruktur in jeder Vertiefung,
Fig. 6: eine Seitenansicht eines radarbasierten Füllstandsensors mit einer dielektrischen Linse,
Fig. 7: a) eine Seitenansicht eines Halbleiterelements auf einer Leiterkarte und eine Übergangsstruktur,
   b) eine Seitenansicht eines Halbleiterelements und Übergangsstruktur auf einer Leiterkarte,
   c) eine Seitenansicht einer Übergangsstruktur, und
Fig. 8 zeigt ein Längsschnitt eines radarbasierten Füllstandsensors entsprechend Fig. 1 mit einem dielektrischen Wellenleiter.

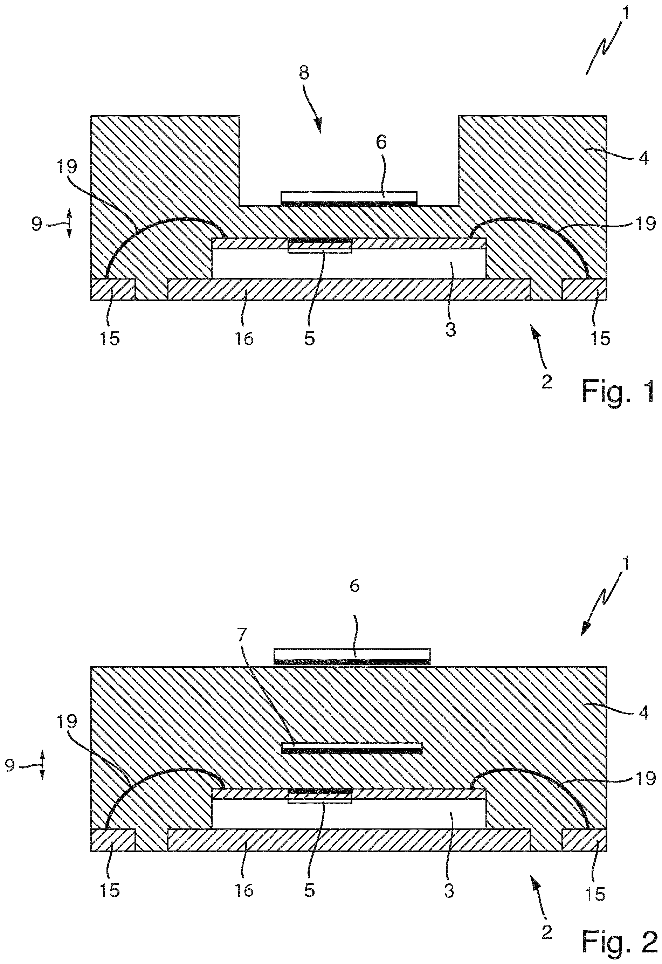

Fig. 1 zeigt einen Querschnitt eines radarbasierten Füllstandsensors 1 mit einem Halbleiterelement 2. Das Halbleiterelement 2 umfasst einen Halbleiter-Chip 3 und ein Chipgehäuse 4, in dem der Halbleiter-Chip 3 angeordnet ist. Der Halbleiter-Chip 3 weist ein Koppelelement 5 auf, das als Signaltor für elektromagnetische Wellen im Millimeterwellenbereich, dient. Erfindungsgemäß ist an einer Teiloberfläche des Chipgehäuses 4 eine erste Resonatorstruktur 6 angeordnet.

Das Chipgehäuse 4 weist, an der Teiloberfläche, an welcher die erste Resonatorstruktur 6 angeordnet ist, eine Vertiefung 8 in Richtung des Koppelelements 5 auf, so dass der Abstand 9 zwischen der ersten Resonatorstruktur 6 und dem Koppelelement 5 an der Stelle der Vertiefung 8 verringert ist.

Das Koppelelement 5 auf dem Halbleiter-Chips 3 ist als ein kurzgeschlossener sehr breiter Lambda/4-Transformator ausgebildet. Die Abstrahlung in den Freiraum erfolgt über eine Resonatorstruktur 6, die als Patch oder dielektrische Resonatorstruktur ausgeführt ist.

Ferner sind Leads 15 des Chipgehäuses 4 mittels Bonddrähten 19 mit Bondpads des Halbleiter-Chips 3 für niederfrequente Signale und Stromversorgungen verbunden.

Fig. 2 zeigt ein Querschnitt eines radarbasierten Füllstandsensors 1 mit einem Halbleiterelement 2 umfassend eine erste und eine zweite Resonatorstruktur 6, 7, wobei die zweite Resonatorstruktur 7 zwischen dem Koppelelement 5 und der ersten Resonatorstruktur 6 angeordnet ist. Dabei weist das Chipgehäuse bei der in Fig. 2 gezeigten Ausführungsvariante an derjenigen Teiloberfläche, an welcher die mindestens erste Resonatorstruktur 6 angeordnet ist, entgegen der Erfindung keine Vertiefung 8 in Richtung des mindestens einen Halbleiter-Chips 3 auf.

Dies ist eine Zusatzoption zu der Ausgestaltung entsprechend Fig. 1 und stellt eine gestapelte Patch-Anordnung dar. Dabei wurde vor dem Verguss des Chipgehäuses 4 eine zweite Resonatorstruktur 7 in Form eines kleinen metallischen Substratplättchens über dem Halbleiter-Chip 3 angebracht. Dadurch erübrigt sich der Prozessschritt zur Erzeugung der Vertiefung, so dass nur noch die erste Resonatorstruktur 6 auf das Gehäuse aufgebracht werden muss.

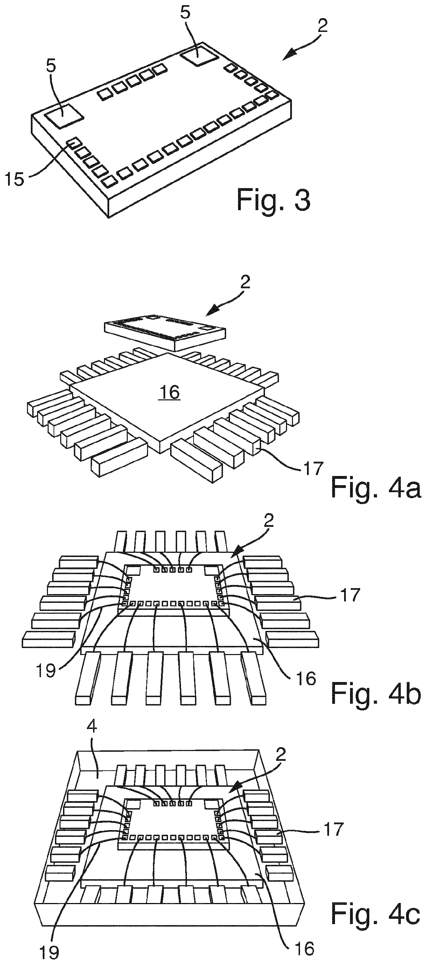

Das erfindungsgemäße Verfahren wird anhand der Figuren 3 - 5 im Detail erläutert. Nach Durchlaufen des Halbleiterprozesses und Vereinzeln liegt ein monolithisch integriertes Halbleiterelement 2 vor, auf dem alle Schaltungsteile zur Erzeugung und Verarbeitung von Millimeterwellensignalen realisiert sind. Das Halbleiterelement 2 weist zahlreiche Bondpads 15 auf, über die sämtliche analoge und digitale Signale bei tiefen Frequenzen übertragbar sind.

Gegenüber einem herkömmlichen Halbleiterelement unterscheidet es sich lediglich dadurch, dass es Koppelstrukturen in Form von zwei Koppelelementen 5 als Signaltore bei Millimeterwellenfrequenzen enthält. Das Halbleiterelement 2 wird nun zunächst in ein typisches Chipgehäuse eingebaut, wobei die in Figuren 4 a - c dargestellten drei Schritte der Herstellung des Chipgehäuses durchlaufen werden. Im ersten Schritt (Fig. 4a) wird das Halbleiterelement 2 auf dem sog. Leadframe, der aus dem Exposed-Pad 16 und den Leads 17 besteht aufgeklebt. Im zweiten Schritt (Fig. 4b) erfolgt das Verbinden der Bondpads 15 mittels Bonddrähten 19 mit den Leads 17. Im dritten Schritt (Fig. 4c) wird die kontaktierte Anordnung mit Kunststoff vergossen. So entsteht das Chip-Gehäuse 4. Alle drei Schritte werden in Nutzen (Arrays) von vielen Bausteinen durchgeführt und erst nach dem Vergießen werden die Bausteine durch Sägen oder Stanzen vereinzelt. Der bis hierhin beschriebene Häusungsvorgang entspricht dem bekannten Stand der Technik der Herstellung von Chipgehäusen.

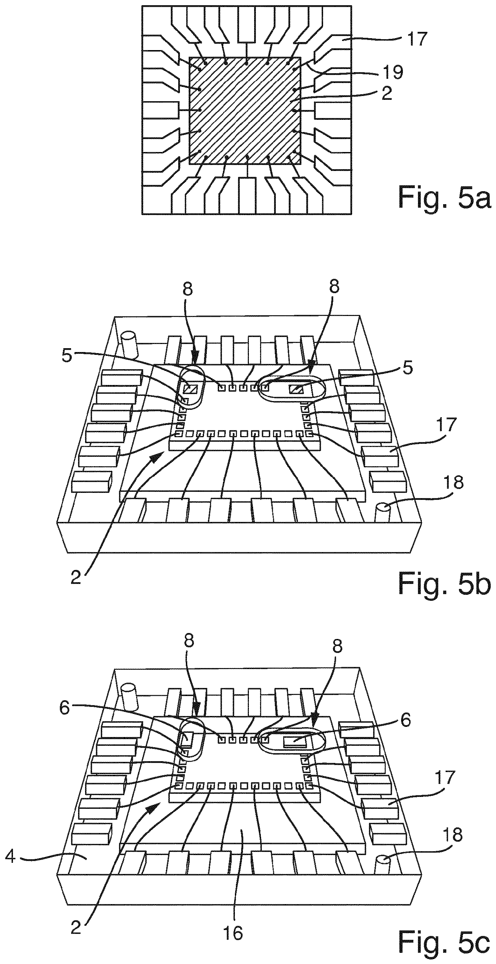

Die erfindungsgemäßen Schritte sind in Fig. 5a - c dargestellt. Im ersten Schritt wird das Chipgehäuse durch Röntgenstrahlung so abgebildet, dass aus der Röntgenabbildung (Fig. 5a) die genaue Position des Halbleiterelements 2 auf dem Exposed Pad 16 und relativ zu seinen Kanten ermittelt werden kann. Mit den Positionsdaten und dem bekannten Chiplayout können nun im zweiten Schritt mittels eines abtragenden Verfahrens wie beispielsweise Fräsen, Laserbearbeitung über allen Koppelelementen 5 Vertiefungen 8 im Verguss hergestellt werden. Zusätzlich können Montagehilfen oder Markierungen wie z. B. Bohrungen 18 in definiertem Abstand zu den Koppelelementen 5 im Gehäuseverguss angebracht werden. In die Vertiefungen 8 werden schließlich im dritten Schritt erste Resonatorstrukturen 6 eingebracht, welche die integrierten Antennen darstellen. Im einfachsten Fall sind solche Resonatorstrukturen als Resonatoren wie rechteckige Metallplättchen ausgestaltet, deren eine Kantenlänge einer halben Wellenlänge (Resonanzlänge) der elektromagnetischen Wellen im Millimeterwellenbereich entspricht. Es sind jedoch auch dielektrische Resonatoren wie beispielsweise Quarzglas, Keramik, Kunststoff oder strukturierte Substratplättchen anwendbar. Neben dem Einbringen von vorgefertigten Resonatoren in die Vertiefungen 8, sind auch das Aufbringen von Resonatorstrukturen mittels 2D/3D-Druck oder MID denkbar.

Die eingebrachten Vertiefungen 8 haben in dem Verfahren die folgenden zentralen Funktionen:
a. Herstellung eines definierten Abstands zwischen der ersten Resonatorstruktur 6 und einem dazugehörigen Koppelelement 5 und damit die Korrektur von möglichen Dickenschwankungen im Verguss.
b. Mechanische Ausrichtung und Befestigung der Resonatorstrukturen.
c. Hohe elektrische Kopplung zwischen den Koppelelementen 5 und den jeweiligen Resonatorstrukturen 6 durch Ausdünnen der Vergussschicht, die im Bereich der Koppelelemente 5 kleiner als die Loophöhen der Bonddrähte 19 ausgeführt sein können.

Durch die erfindungsgemäße Vorgehensweise unter Nutzung der aus einem Röntgenbild ermittelten Maße werden die horizontalen Toleranzen der Lage der ersten Resonatorstrukturen 6 zu den Koppelelementen 5 individuell minimiert. Falls die vertikalen Lagetoleranzen trotz der geringen Dickentoleranzen des Leadframe und der Kleberschicht zur Halbleiter-Montage noch zu groß sind, kann sie basierend auf einer zweiten vertikalen Röntgenaufnahme ebenfalls individuell kompensiert werden.

Die elektrische Überprüfung des nach dem erfindungsgemäßen Verfahren gefertigten Halbleiterelements 2 kann mit einem auf dem Halbleiter-Chip 3 integrierten Selbsttest durchgeführt werden. Dabei wird durch Leistungsmessung erkannt, ob die Abstrahlung an der ersten Resonatorstruktur 6 auf dem Halbleiter-Chip 3 ordnungsgemäß funktioniert oder eine Fehlfunktion an der ersten Resonatorstruktur 6 vorliegt.

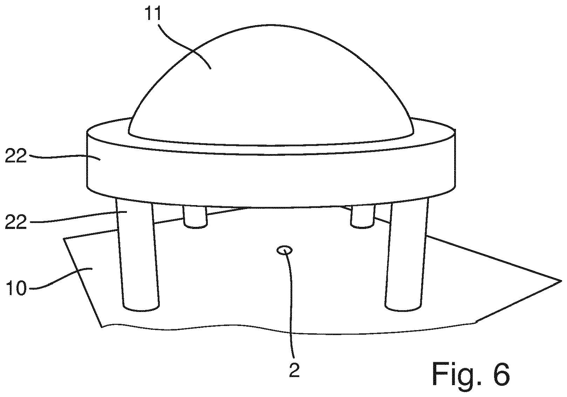

Fig. 6 zeigt ein auf einer Leiterkarte 10 angeordnetes Halbleiterelement 2, wobei eine dielektrische Linse 11 dermaßen an der Leiterkarte 10 befestigt ist, dass das Halbleiterelement 2 in dem Brennpunkt der Linse 11 liegt. Dies ist ein prinzipielles Ausführungsbeispiel einer Anwendung des Halbleiterelements 2 mit einer integrierten Antenne zur Ausleuchtung der dielektrischen Linse 11, durch welche die breite Abstrahlung der integrierten Antenne zu einem hochbündelnden Strahl fokussiert wird. Das Halbleiterelement 2 ist zusammen mit weiteren Elektronikbaugruppen auf der Leiterkarte 10 montiert, wobei seine Position so gewählt ist, dass es im Fokus der dielektrischen Linse 11 liegt, die mittels einer Befestigungsanordnung 22 mit der Leiterkarte 10 fest verbunden ist. Als Befestigungsanordnung 22 kann auch ein Gehäuse dienen, in das die Leiterkarte 10 eingebaut wird.

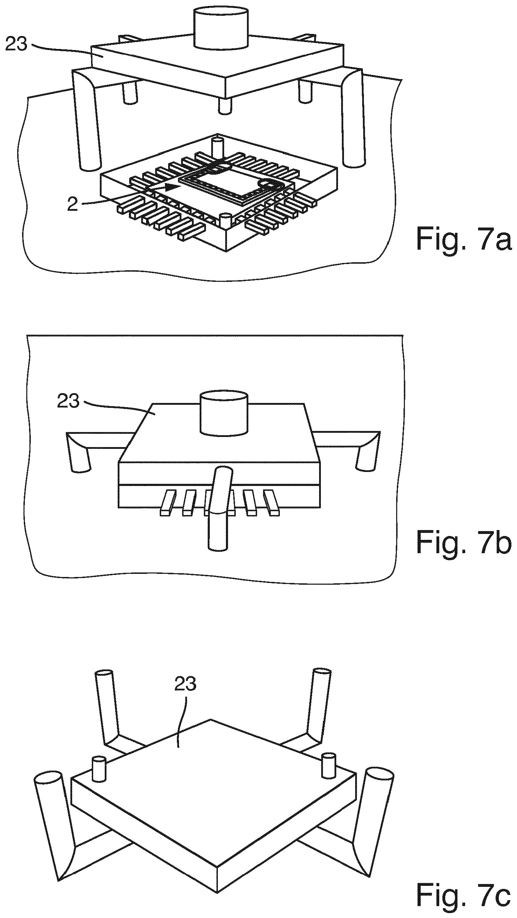

Fig. 7 a - c zeigen ein an einer Leiterkarte 10 angeordnetes Halbleiterelement 2, wobei die Leiterkarte 10 Hohlleiter 12 zum Übertragen der durch das Halbleiterelement 2 erzeugten elektromagnetischen Wellen aufweist. Anstelle freier Abstrahlung wird das Halbleiterelement 2 zur Strahlungseinkopplung in einen Hohlleiter 12 mit rundem oder rechteckigem Querschnitt verwendet. Dazu sind speziell ausgestaltete Resonatoren und eine zusätzlich auf das Package aufgesetzte Übergangsstruktur 23 nötig.

Zur besseren Auswertbarkeit einer Röntgenaufnahme des gepackten Halbleiterelements könnten im Chiplayout spezielle Markerstrukturen in der Nähe der Koppelelemente realisiert werden, die sich durch ihre Metalldichte oder ihre Strukturierung in einer Röntgenabbildung mit besonders hohem Kontrast zeigen.

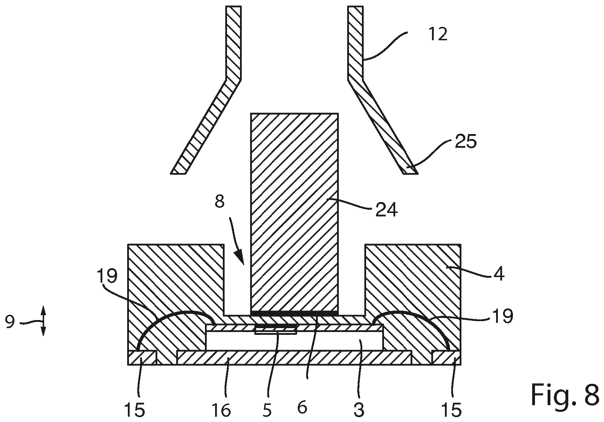

Fig. 8 zeigt ein Längsschnitt eines radarbasierten Füllstandsensors entsprechend Fig. 1 mit einem dielektrischen Wellenleiter 24 in der Vertiefung 8. Der dielektrische Wellenleiter 24 führt elektromagnetischen Wellen, die von dem Koppelelement 5 ausgekoppelt werden zu dem Hohlleiter 12 (siehe Fig. 7a - 7c), und elektromagnetischen Wellen, die von dem Hohlleiter 12 übertragen werden zu dem Koppelelement 5.

Der Hohlleiter 12 besitzt eine Abschlussstruktur 25, die einen verlustarmen Übergang über den dielektrischen Wellenleiter 24 in den Hohlleiter 12 ermöglicht. Durch den Wellenleiter 24 kann zusätzlich eine galvanische Trennung zwischen Radar-Frontend und einer metallischen Antennenstruktur erreicht werden, die bei Radargeräten der Prozessmesstechnik aus Gründen des EX-Schutzes häufig vorgeschrieben ist.

### Bezugszeichenliste

- 1: Füllstandsensor
- 2: Halbleiterelement
- 3: Halbleiter-Chip
- 4: Chipgehäuse
- 5: Koppelelement
- 6: Erste Resonatorstruktur
- 7: Zweite Resonatorstruktur
- 8: Vertiefung
- 9: Abstand zwischen der ersten und zweiten Resonatorstruktur
- 10: Leiterkarte
- 11: Linse
- 12: Hohlleiter
- 15: Lead
- 16: Exposed-Pad
- 18: Bohrung
- 19: Bonddraht
- 22: Befestigungsanordnung
- 23: Übergangsstruktur
- 24: Dielektrischer Wellenleiter
- 25: Abschlussstruktur

## Patentansprüche

1. Radarbasierter Füllstandsensor mit mindestens einem Halbleiterelement (2), umfassend mindestens ein Halbleiter-Chip (3) und ein Chipgehäuse (4), in dem der mindestens eine Halbleiter-Chip (3) angeordnet ist,
wobei der mindestens eine Halbleiter-Chip (3) mindestens ein Koppelelement (5) aufweist, das als Signaltor für elektromagnetische Wellen, bevorzugt im Millimeterwellenbereich, dient,
**dadurch gekennzeichnet, dass**
an einer Teiloberfläche des Chipgehäuses (4) mindestens eine erste dielektrische Resonatorstruktur (6), die aus Quarzglas, Keramik oder Kunststoff gefertigt ist, derart angeordnet ist, so dass das Chipgehäuse (4) die Resonatorstruktur (6) definiert vom Koppelelement (5) beabstandet,
wobei das Chipgehäuse (4), an der Teiloberfläche, an welcher die mindestens erste Resonatorstruktur (6) angeordnet ist, eine Vertiefung (8) in Richtung des mindestens einen Halbleiter-Chips (3) aufweist.

2. Radarbasierter Füllstandsensor mit mindestens einem Halbleiterelement (2), umfassend mindestens ein Halbleiter-Chip (3) und ein Chipgehäuse (4), in dem der mindestens eine Halbleiter-Chip (3) angeordnet ist,
wobei der mindestens eine Halbleiter-Chip (3) mindestens ein Koppelelement (5) aufweist, das als Signaltor für elektromagnetische Wellen, bevorzugt im Millimeterwellenbereich, dient,
**dadurch gekennzeichnet, dass**
an einer Teiloberfläche des Chipgehäuses (4) mindestens eine erste dielektrische Resonatorstruktur (6), die aus Quarzglas, Keramik oder Kunststoff gefertigt ist, derart angeordnet ist, so dass das Chipgehäuse (4) die Resonatorstruktur (6) definiert vom Koppelelement (5) beabstandet,
wobei zwischen dem Halbleiter-Chip (3) und der mindestens ersten Resonatorstruktur (6) mindestens eine zweite Resonatorstruktur (7) angeordnet ist, und
wobei das Chipgehäuse (4) an der Teiloberfläche, an welcher die mindestens erste Resonatorstruktur (6) angeordnet ist, eine Vertiefung (8) in Richtung der mindestens zweiten Resonatorstruktur (7) aufweist.

3. Füllstandsensor nach mindestens einem der vorhergehenden Ansprüche, wobei das Halbleiterelement (2) an einer Leiterkarte (10) angeordnet ist, wobei eine dielektrische Linse (11) dermaßen an der Leiterkarte (10) befestigt ist, dass das Halbleiterelement (2) in dem Brennpunkt der der Linse (11) liegt.

4. Füllstandsensor nach mindestens einem der vorhergehenden Ansprüche, wobei das Halbleiterelement (2) an einer Leiterkarte (10) angeordnet ist, wobei Hohlleiter (12) zum Übertragen der durch das Halbleiterelement (2) erzeugten elektromagnetischen Wellen an der Leiterkarte (10) angeordnet sind.

5. Füllstandsensor nach dem vorhergehenden Anspruch, wobei ein dielektrischer Wellenleiter (24) in der Vertiefung (8) angeordnet ist, so dass die von dem Koppelelement (5) ausgekoppelten elektromagnetischen Wellen mittels des dielektrischen Wellenleiters (24) in einen Hohlleiter (12) geführt werden, der bevorzugt eine Anschlussstruktur (25) zum Einkoppeln der elektromagnetischen Wellen aufweist.

6. Verfahren zum Herstellen eines radarbasierten Füllstandsensors entsprechend mindestens einem der vorhergehenden Ansprüche, umfassend die Verfahrensschritte:
Durchleuchten des Halbleiterelements (2), so dass eine Lage des Halbleiter-Chips (3) relativ zum Chipgehäuse (4) bestimmbar ist,
teilweises Abtragen des Chipgehäuses (4), bis eine Teiloberfläche des Chipgehäuses (4) mindestens eine Vertiefung (8) in Richtung des mindestens einen Koppelelements (5) aufweist,
Erzeugen einer ersten Resonatorstruktur (6) in der mindestens einen Vertiefung (8), so dass der Abstand (9) zwischen der mindestens ersten Resonatorstruktur (6) und dem Koppelelement (5) des Halbleiter-Chips (3) verringert ist,
wobei die erste Resonatorstruktur (6) als eine dielektrische Resonatorstruktur, die aus Quarzglas, Keramik oder Kunststoff gefertigt ist, ausgestaltet ist.

7. Verfahren nach Anspruch 6, wobei das Erzeugen der ersten Resonatorstruktur (6) in der mindestens einen Vertiefung mittels 2D- oder 3D-Druck-Verfahren oder MID-Verfahren geschieht.

8. Verfahren nach Anspruch 6 oder 7, wobei das Durchleuchten des Halbleiterelements (2) mittels Röntgenstrahlung geschieht.

9. Verfahren nach mindestens einem der Ansprüche 6 bis 8, wobei das teilweise Abtragen des Chipgehäuses (4) mittels Fräsen oder Laserbearbeitung geschieht.

10. Verfahren nach mindestens einem der Ansprüche 6 bis 9, wobei die erste Resonatorstruktur (6) ein rechteckiges Metallplättchen (13) umfasst, und wobei eine Kantenlänge (14) der ersten Resonatorstruktur (6) einer halben Wellenlänge oder dem ganzzahligen Vielfachen einer halben Wellenlänge der elektromagnetische Wellen entspricht.

## Claims

1. A radar based fill-level sensor having at least one semiconductor element (2), comprising at least one semiconductor chip (3) and one chip package (4), in which the at least one semiconductor chip (3) is arranged,
the at least one semiconductor chip (3) having at least one coupling element (5), which serves as a signal gate for electromagnetic waves, preferably in the millimeter wave range,
wherein
at least one first dielectric resonator structure (6), which is made of quartz glass, ceramic or plastic, is arranged on a surface portion of the chip package (4) in such a way that the chip package (4) produces a defined distance between the resonator structure (6) and the coupling element (5),
the chip package (4) having, on the surface portion on which the at least first resonator structure (6) is arranged, a depression (8) in the direction of the at least one semiconductor chip (3).

2. A radar-based fill-level sensor having at least one semiconductor element (2), comprising at least one semiconductor chip (3) and a chip package (4), in which the at least one semiconductor chip (3) is arranged,
the at least one semiconductor chip (3) having at least one coupling element (5), which serves as a signal gate for electromagnetic waves, preferably in the millimeter wave range,
wherein
at least one first dielectric resonator structure (6), which is made of quartz glass, ceramic or plastic, is arranged on a surface portion of the chip package (4) in such a way that the chip package (4) produces a defined distance between the resonator structure (6) and the coupling element (5),
at least one second resonator structure (7) being arranged between the semiconductor chip (3) and the at least first resonator structure (6), and
the chip package (4) having, on the surface portion on which the at least first resonator structure (6) is arranged, a depression (8) in the direction of the at least second resonator structure (7).

3. The fill-level sensor as claimed in at least one of the preceding claims, wherein the semiconductor element (2) is arranged on a printed circuit board (10), wherein the dielectric lens (11) is secured to the printed circuit board (10) in such a way that the semiconductor element (2) lies in the focal point of the lens (11).

4. The fill-level sensor as claimed in at least one of the preceding claims, wherein the semiconductor element (2) is arranged on a printed circuit board (10), wherein hollow conductors (12) are arranged on the printed circuit board (10) for transferring the electromagnetic waves produced by the semiconductor element (2).

5. The fill-level sensor according to the preceding claims, wherein a dielectric waveguide (24) is arranged in the depression (8), so that the electromagnetic waves out-coupled from the coupling element (5) are led by means of the dielectric waveguide (24) into a hollow conductor (12), which preferably has a terminal structure (25) for in-coupling the electromagnetic waves.

6. The method for producing a radar-based fill-level sensor as claimed in at least one of the preceding claims, comprising the method steps of:
sending radiation through the semiconductor element (2) so that a position of the semiconductor chip (3) relative to the chip package (4) can be determined,
partially removing the chip package (4) until a surface portion of the chip package (4) has at least one depression (8) in the direction of the at least one coupling element (5),
producing a first resonator structure (6) in the at least one depression (8), so that the distance (9) between the at least first resonator structure (6) and the coupling element (5) of the semiconductor chip (3) is reduced,
wherein the first resonator structure (6) is embodied as a dielectric resonator structure formed from quartz glass, ceramic or plastic.

7. The method as claimed in claim 6, wherein the first resonator structure (6) in the at least one depression is produced by means of a 2D or 3D printing method or an MID method.

8. The method as claimed in claim 6 or 7, wherein the radiation is sent through the semiconductor element (2) by means of x-rays.

9. The method as claimed in at least any one of claims 6 to 8, wherein the partial removal of the chip package (4) is performed by means of milling or laser machining.

10. The method as claimed in at least any one of claims 6 to 9, wherein the first resonator structure (6) comprises a rectangular metal platelet (13), and wherein an edge length (14) of the first resonator structure (6) corresponds to a half wavelength or an integer multiple of a half wavelength of the electromagnetic waves.

## Revendications

1. Capteur de niveau basé sur un radar avec au moins un élément semi-conducteur (2), lequel capteur comprend au moins une puce semi-conductrice (3) et un boîtier de puce (4), boîtier dans lequel est disposée l'au moins une puce semi-conductrice (3), l'au moins une puce semi-conductrice (3) présentant au moins un élément de couplage (5), lequel sert de porte de signal pour des ondes électromagnétiques, de préférence dans la gamme des ondes millimétriques, **caractérisé en ce qu'**
au moins une première structure de résonateur diélectrique (6), laquelle est fabriquée en verre de quartz, en céramique ou en matière plastique, est disposée sur une surface partielle du boîtier de puce (4), de telle sorte que le boîtier de puce (4) place la structure de résonateur (6) à une distance définie de l'élément de couplage (5), le boîtier de puce (4) présentant, sur la surface partielle sur laquelle est disposée l'au moins première structure de résonateur (6), un renfoncement (8) en direction de l'au moins une puce semi-conductrice (3).

2. Capteur de niveau basé sur un radar avec au moins un élément semi-conducteur (2), lequel capteur comprend au moins une puce semi-conductrice (3) et un boîtier de puce (4), boîtier dans lequel est disposée l'au moins une puce semi-conductrice (3), l'au moins une puce semi-conductrice (3) présentant au moins un élément de couplage (5), lequel sert de porte de signal pour des ondes électromagnétiques, de préférence dans la gamme des ondes millimétriques, **caractérisé en ce qu'**
au moins une première structure de résonateur diélectrique (6), laquelle est fabriquée en verre de quartz, en céramique ou en matière plastique, est disposée sur une surface partielle du boîtier de puce (4) de telle sorte que le boîtier de puce (4) place la structure de résonateur (6) à une distance définie de l'élément de couplage (5),
au moins une deuxième structure de résonateur (7) étant disposée entre la puce semi-conductrice (3) et l'au moins première structure de résonateur (6),
le boîtier de puce (4) présentant, sur la surface partielle sur laquelle est disposée l'au moins première structure de résonateur (6), un renfoncement (8) en direction de l'au moins deuxième structure de résonateur (7).

3. Capteur de niveau selon au moins l'une des revendications précédentes, pour lequel l'élément semi-conducteur (2) est disposé sur une carte de circuit imprimé (10), une lentille diélectrique (11) étant fixée à la carte de circuit imprimé (10) de telle sorte que l'élément semi-conducteur (2) se trouve au foyer de la lentille (11).

4. Capteur de niveau selon au moins l'une des revendications précédentes, pour lequel l'élément semi-conducteur (2) est disposé sur une carte de circuit imprimé (10), des guides d'ondes creux (12) étant disposés sur la carte de circuit imprimé (10) pour transmettre les ondes électromagnétiques générées par l'élément semi-conducteur (2).

5. Capteur de niveau selon la revendication précédente, pour lequel un guide d'ondes diélectrique (24) est disposé dans la cavité (8), de sorte que les ondes électromagnétiques découplées par l'élément de couplage (5) sont guidées au moyen du guide d'ondes diélectrique (24) dans un guide d'ondes creux (12), lequel présente de préférence une structure de raccordement (25) pour le couplage des ondes électromagnétiques.

6. Procédé destiné à la fabrication d'un capteur de niveau basé sur un radar selon au moins l'une des revendications précédentes, lequel procédé comprend les étapes suivantes :
Transillumination de l'élément semi-conducteur (2) de manière à pouvoir déterminer une position de la puce semi-conductrice (3) par rapport au boîtier de puce (4),
Enlèvement de matière partiel du boîtier de puce (4) jusqu'à ce qu'une surface partielle du boîtier de puce (4) présente au moins un renfoncement (8) en direction de l'au moins un élément de couplage (5),
Création d'une première structure de résonateur (6) dans l'au moins un renfoncement (8), de sorte que la distance (9) entre l'au moins première structure de résonateur (6) et l'élément de couplage (5) de la puce semi-conductrice (3) est réduite,
la première structure de résonateur (6) étant conçue comme une structure de résonateur diélectrique qui est fabriquée en verre de quartz, en céramique ou en matière plastique.

7. Procédé selon la revendication 6, pour lequel la création de la première structure de résonateur (6) dans l'au moins un renfoncement se fait au moyen d'un procédé d'impression 2D ou 3D ou d'un procédé MID.

8. Procédé selon la revendication 6 ou 7, pour lequel la transillumination de l'élément semi-conducteur (2) est effectuée au moyen de rayons X.

9. Procédé selon au moins l'une des revendications 6 à 8, pour lequel l'enlèvement de matière partiel du boîtier de puce (4) est effectué par fraisage ou par usinage au laser.

10. Procédé selon au moins l'une des revendications 6 à 9,
pour lequel la première structure de résonateur (6) comprend une plaquette métallique rectangulaire (13), et
pour lequel une longueur de bord (14) de la première structure de résonateur (6) correspond à une demi-longueur d'onde ou à un multiple entier d'une demi-longueur d'onde des ondes électromagnétiques.
